# EUROPEAN PATENT APPLICATION

(11) **EP 2 163 367 A1**
(43) Date of publication of application: **17.03.2010**
(21) Application number: 08763996.9
(22) Date of filing: 03.06.2008
(51) Int. Cl.: B29C 33/40, B29C 59/02, H01L 21/027

(54) **FORM, MICROPROCESSED ARTICLE, AND THEIR MANUFACTURING METHODS**

(30) Priority: 04.06.2007 JP 2007148213; 03.12.2007 JP 2007312424
(71) Applicant: Scivax Corporation, Kanagawa 2130012 (JP); Maruzen Petrochemical Co. Ltd., Chuo-ku Tokyo 104-8502 (JP)
(72) Inventor: KUSUURA, Takahisa, Kawasaki-shi Kanagawa 213-0012 (JP); MITRA, Anupam, Kawasaki-shi Kanagawa 213-0012 (JP); TAKAYA, Yoshiaki, Ichihara-shi Chiba 290-0045 (JP); SATSUKA, Takuro, Ichihara-shi Chiba 290-0045 (JP)
(74) Representative: Gille Hrabal Struck Neidlein Prop Roos
(86) International application number: PCT/JP2008/001399
(87) International publication number: WO 2008/149544

(57) **Abstract**

A mold 100 for imprinting has a mold pattern 2A for transferring a pattern to a processing object. A base layer 1 having a predetermined base pattern 1A is formed by imprinting on a thermoplastic resin, a thermosetting resin, a photo-curable resin, or the like, and a mold layer 2 is formed in such a way that the mode pattern 2A is shapened along a surface of the base pattern 1A by a surface preparation technique, such as CVD, PVD, or plating. Accordingly, there is provided a mold which has the same functions as those of conventionally-used silicon mold and metal mold and which facilitates manufacturing thereof.

## Description

### Technical Field

The present invention relates to a mold for transferring a fine pattern, a fine pattern product formed by same, and a method of manufacturing those.

### Background Art

Getting attention recent years are nanoimprinting technologies of pressing a processing object like a resin against a die and of transferring a fine pattern in a micro nanometer or nanometer order (see, for example, patent literature 1).

Examples of such a mold used in nanoimprinting technologies are molds formed of silicon or a metal, and ones formed of a resin on which a pattern is transferred from the molds of the foregoing type and which is used as a resin-made mold (see, for example, patent literature 2).

Patent Literature 1: WO2004/062886
Patent Literature 2: JP2007-55235A

### Disclosure of Invention

### Problem to be Solved by the Invention

The molds formed of silicon have a pattern formed on a silicon substrate by semiconductor microfabrication techniques, such as photo lithography and etching. The molds formed of a metal have a pattern formed by electroforming (e.g., nickel plating) that a metal plating is formed on a surface of a silicon-made mold and the metal plating layer is peeled off.

Such molds formed in those fashions, however, are very expensive and require a time for manufacturing. Moreover, because of a difference in thermal expansion between the mold and a processing object, a transferred pattern may be damaged and demolding may become difficult as the mold and the processing object adhere to each other.

Conversely, regarding the resin-made molds, a pattern is transferred between a mold formed of a different kind of resin and a processing object, such as a transfer from a mold formed of polycarbonate to a film formed of cyclic olefin polymer, and a transfer from a mold formed of cyclic-olefin-based copolymer to a photo-curable resist. However, technologies have not been developed well to transfer a pattern between resins of the same kind having extremely small difference in thermal expansion coefficients that is expected as effective from the standpoint of demolding. This is because resins are coupled together at the boundary faces of the mold and the processing object if a pattern is transferred between the mold formed of the same kind of resin and the processing object, resulting in difficulty of demolding.

Moreover, a mold release agent may be applied on the resin-made mold, but the resin-made mold has a poor wettability and repels the mold release agent, so that a demolding layer cannot be formed uniformly.

Furthermore, the resin-made mold has a poor strength, and cannot withstand several usages. In order to overcome such a problem, a relative strength of the mold to the processing object may be ensured by setting a molding temperature to be sufficiently higher than a glass transition temperature. In order to do so, however, it is necessary to set the glass transition temperature of a resin to be used as a mold to be sufficiently higher than the glass transition temperature of the processing object, so that the kinds of resins which can match this condition are limited.

Accordingly, it is an object of the present invention to provide a mold which can be easily manufactured, is small in cost, has a sufficient strength to withstand several usages, and can overcome the problems relating to thermal expansion and a demolding property, a fine pattern product manufactured by same, and a method of manufacturing those.

### Means for Solving the Problem

To achieve the object, a mold for nanoimprinting according to a first aspect of the present invention includes a mold pattern to be transferred to a processing object, the mold comprises: a base layer formed of a resin and including a predetermined base pattern; and a mold layer formed along the base pattern so as to shape the mold pattern.

A mold for nanoimprinting according to a second aspect of the present invention includes a mold pattern to be transferred to a processing object, the mold comprises: a base layer including a predetermined base pattern; and a mold layer formed along the base pattern so as to shape the mold pattern and having a thickness less than or equal to 100 nm.

In those cases, it is preferable that the mold layer should be formed of a material harder than the resin at least at a molding temperature of performing imprinting on the processing object. The mold layer may be formed of an inorganic compound, such as platinum or nickel. A hydrophilic group may be formed on a surface of the mold layer. The resin may be a thermoplastic resin, such as a cyclic olefin-based resin, an acrylic resin, polycarbonate, vinyl ether, or fluorinated resin. The resin may be a thermosetting resin or a photo-curable resin. It is preferable that the resin should have a water absorption percentage less than or equal to 3 %. The base pattern may be formed so as to have a minimum size in a planar direction less than or equal to 100 µm. A demolding layer formed on a surface of the mold pattern and suppressing any adhesion with the processing object may be further formed. In this case, the demolding layer may be a fluorinated mold release agent.

A method of manufacturing a mold for nanoimprinting according to a third aspect of the present invention in which the mold including a mold pattern to be transferred to a processing object, the method comprises: a base layer formation step of forming a base layer formed of a resin and including a predetermined base pattern; and a mold layer formation step of forming a mold layer along the base pattern so as to shape the mold pattern.

A method of manufacturing a mold for nanoimprinting according to a fourth aspect of the present invention in which the mold including a mold pattern to be transferred to a processing object, the method comprises: a base layer formation step of forming a base layer including a predetermined base pattern; and a mold layer formation step of forming a mold layer along the base pattern so as to shape the mold pattern and so as to have a thickness less than or equal to 100 nm.

In those cases, the mold layer formation step may form the mold layer by any one of following fashions: physical vapor deposition (PVD); chemical vapor deposition (CVD); and plating. The base layer formation step may form the base layer by imprinting. The mold manufacturing method may further comprise a demolding layer formation step of forming a demolding layer on a surface of the mold pattern, the demolding layer suppressing any adhesion with the processing object.

A fine pattern product according to a fifth aspect of the present invention comprises: the mold of the present invention; and a molded layer formed by joining with the mold.

A method of manufacturing a fine pattern product according to a sixth aspect of the present invention manufactures the fine pattern product by joining and imprinting the mold of the present invention with a processing object.

### Effect of the Invention

The mold of the present invention comprises the base layer having the predetermined base pattern, and the mold layer formed along the base pattern, a difference in thermal expansion from the processing object can be reduced by the base layer, and the strength and demolding property can be improved by the mold layer.

Regarding the mold manufacturing method, because the base layer is formed using a resin easy to process, and the mold layer formed of a material relatively difficult to process on the base layer, so that manufacturing of the mold can be carried out simply and at short times, resulting in cost reduction.

### Brief Description of Drawings

FIG. is a cross-sectional view showing a mold of the present invention;
FIG. 2 is a cross-sectional view showing a fine pattern product of the present invention;
FIG. 3 is a cross-sectional view showing another fine pattern product of the present invention;
FIG. 4 is a diagram showing a relationship between stress (force) and strain (displacement) due to nanoindentation of a resin used as a base layer;
FIG. 5 is a diagram showing a relationship between stress and strain due to nanoindentation of the mold of the present invention;
FIG. 6 is a graph showing a condition of a cross-section of a pattern formed on a base layer;
FIG. 7 is a graph showing a condition of a cross-section of a mold C after transferring is performed 26 times;
FIG. 8 is a graph showing a condition of a cross-section of a pattern transferred from the mold C at the second time;
FIG. 9 is a graph showing a condition of a cross-section of a pattern transferred from the mold C at the twenty-seventh time;
FIG. 10 is an AFM image showing a pattern of a nickel metal mold used for manufacturing a mold D;
FIG. 11 is a graph showing a condition of a cross-section of the nickel metal mold used for manufacturing the mold D;
FIG. 12 is an AFM image showing a pattern of the mold D;
FIG. 13 is a graph showing a condition of a cross-section of the pattern of the mold D;
FIG. 14 is an AFM image showing a pattern transferred from the mold D;
FIG. 15 is a graph showing a condition of a cross-section of the pattern transferred from the mold D;
FIG. 16 is an AFM image showing a pattern transferred from a mold G of the present invention;
FIG. 17 is a graph showing a condition of a cross-section of the pattern transferred from the mold G of the present invention;
FIG. 18 is an AFM image showing a pattern transferred from a mold H of the present invention;
FIG. 19 is a graph showing a condition of a cross-section of the pattern transferred from the mold H of the present invention;
FIG. 20 is an AFM image showing a pattern of a mold I;
FIG. 21 is a graph showing a condition of a cross-section of the pattern of the mold I;
FIG. 22 is an AFM image showing a pattern transferred from the mold I;
FIG. 23 is a graph showing a condition of a cross-section of the pattern transferred from the mold I;
FIG. 24 is an AFM image showing a pattern transferred from a mold J of the present invention;
FIG. 25 is a graph showing a condition of a cross-section of the pattern transferred from the mold J of the present invention;
FIG. 26 is an AFM image showing a pattern transferred from a mold K of the present invention;
FIG. 27 is a graph showing a condition of a cross-section of the pattern transferred from the mold K of the present invention;
FIG. 28 is an AFM image showing a pattern transferred from the mold I of the present invention; and
FIG. 29 is a graph showing a condition of a cross-section of the pattern transferred from the mold I of the present invention.

### Description of Reference Numerals

- 1: Base layer
- 1A: Base pattern
- 2: Mold layer
- 2A: Mold pattern
- 3: Molding-target layer
- 100: Mold
- 200: Fine pattern product
- 300: Fine pattern product

### Best Mode for Carrying Out the Invention

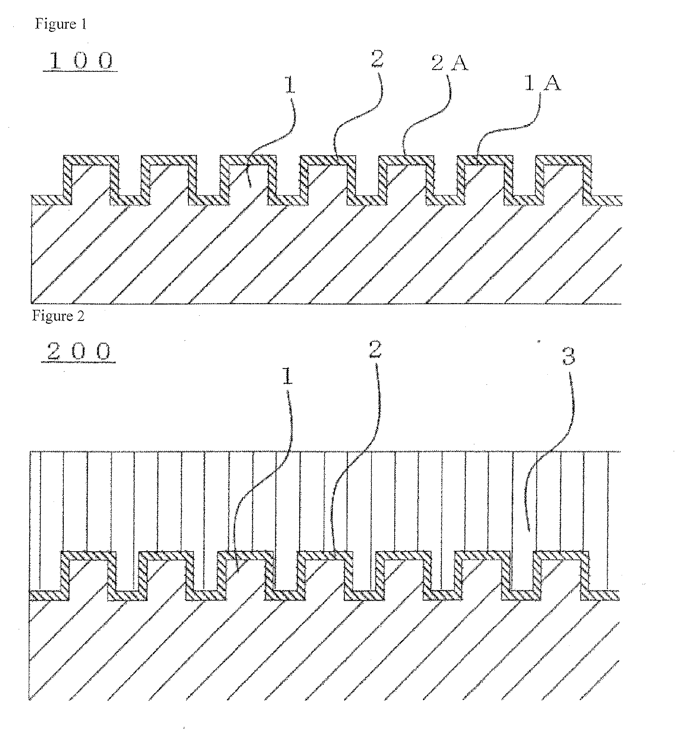

As shown in FIG. 1, a mold 100 of the present invention is a mold for imprinting having a mold pattern 2A to be transferred to a processing object, and mainly comprises a base layer 1 having a predetermined base pattern 1A, and a mold layer 2 formed along the base pattern 1 A so as to shapen the mold pattern 2A.

The base pattern 1 A and the mold pattern 2A are not limited to a geometrical shape comprise of concavities and convexities, but include, for example, one for transferring a predetermined surface condition like transferring of a mirror condition with a predetermined surface roughness, and one for transferring an optical element like a lens with a predetermined curved surface.

The base pattern 1A and the mold pattern 2A can be formed with various sizes such that a minimum size of a width of a convexity in a planar direction and that of a concavity is less than or equal to 100 µm, less than or equal to 10 µm, less than or equal to 2 µm, less than or equal to 1 µm, less than or equal to 100 nm, and less than or equal to 10 nm. Moreover, a size in the depth direction can be set in various sizes, such as greater than or equal to 10 nm, greater than or equal to 100 nm, greater than or equal to 200 nm, greater than or equal to 500 nm, greater than or equal to 1 µm, greater than or equal to 10 µm, and greater than or equal to 100 µm. Various aspect ratios, such as greater than or equal to 0.2, greater than or equal to 0.5, greater than or equal to 1, and greater than or equal to 2 can be also set.

The base layer 1 is formed in various shapes, such as a substrate-like shape, and a film-like shape. A material of the base layer 1 can be one which can form the base pattern 1A, and examples of such a material are thermoplastic resins, such as a cyclic-olefin-based resin like a cyclic olefin ring-opening polymer/hydrogen-added material (COP) or a cyclic olefin copolymer (COC), an acrylic resin, polycarbonate, vinyl ether, a fluorine resin like perfluoroalkoxylalkane (PFA) or polytetrafluoroethylene (PTFE), polystyrene, and a polyimide-based resin. Moreover, resins formed by polymerization reaction (thermal curing, or photo curing) of polymerization-reactive-group containing compounds like unsaturated hydrocarbon-group-containing compounds of vinyl group/allylic group, such as epoxide-containing compounds, (meta) acrylic ester compounds, vinylether compounds, and bisallylnadiimide compounds. A polymerization-reactive-group containing compound can be used alone because it thermally polymerizes, and a thermally-reactive initiator can be added in order to improve the thermo-curability. Furthermore, a photoactive initiator can be added to progress a polymerization reaction by irradiation of light, thereby to form the base layer. An organic peroxide, and an azo compound can be appropriately used as the thermally-reactive radical initiator, and an acetophenon derivative a benzophenon derivative, a benzoic ether derivative, a xanthone derivative can be appropriately used as the photoactive radical initiator. A reactive monomer can be used in a solventless condition, or can be dissolved in a solvent, coated, and then desolvented.
Note that from the standpoint of the size stability of a pattern, it is preferable that the water absorption percentage of a resin used for the base layer 1 should be less than or equal to 3 %.

Moreover, when a resin is used for a mold for imprinting, in order to avoid a problem such that pattern may be damaged because of a difference in thermal expansion between the processing object and the mold, it is preferable to select a resin having a thermal expansion coefficient similar to the thermal expansion coefficient of the processing object. An example of such a resin having a similar thermal expansion coefficient is a resin of the same kind having the same repeating unit structure in the skeleton of a resin used for the base layer 1 and in the skeleton of a resin used as the processing object.

In thermal imprinting, the mold 100 is heated at a temperature higher than or equal to a glass transition temperature of the processing object and is then used. Accordingly, it is preferable that the resin used for the base layer 1 should be one having a higher glass transition temperature than that of the processing object. However, a material having a glass transition temperature lower than or equal to that of the processing object can be used depending on a material quality of the mold layer and a strength thereof.
The base layer 1 has the predetermined base pattern 1A. The base pattern 1A can be formed through any techniques, but for example, nanoimprinting technologies, such as thermal imprinting, and optical imprinting, can be applied.

The base layer 1 can have any thicknesses, but it is desirable that the base layer should be so formed as to have a thickness which allows the base layer to deform in accordance with swelling, convexities and concavities of the mold or the processing object when the mold is pressed against the processing object. Because the mold is heated and cooled during an imprint process, it is desirable that the mold should be thinned as much as possible to decrease a thermal capacity. For example, the mold is formed in a size less than or equal to 1 mm, and preferably, less than or equal to 100 µm, but is not limited to such sizes.

The mold layer 2 is for transferring the mold pattern 2A to the processing object, and is formed of a material having a strength, a demolding property and the like all appropriate for imprinting. For example, when the mold 100 is used for thermal imprinting, as a material harder than the resin (a thermoplastic resin, a thermosetting resin, and a photo-curable resin) used for the base layer 1 at a molding temperature at the time of imprinting is used, the mold can have a high strength so as to withstand several usages. In consideration of the molding temperature in thermal imprinting, it is desirable to use a material harder than the resin used for the base layer 1 at least within a range from greater than or equal to 0 °C to less than or equal to 100 °C. An example of such a material is an inorganic compound, such as a metal or a metal compound like platinum (Pt), nickel (Ni), palladium, ruthenium, gold, silver, copper, ZnO, indium tin oxide (ITO), and, Si and SiO₂. Other materials, such as an organic compound like a fluorinated resin can be used if it is harder than the base layer 1 at least within a range from greater than or equal to 0 °C to less than or equal to 100 °C.

Note that regarding the hardness, a Vickers hardness or a Brinell hardness can be compared using a hardness tester at a normal temperature or a molding temperature. Moreover, the hardness can be checked by carrying out a test through nanoindentation.

The mold can have a good demolding property if a material suppressing any adhesion to the processing object or a material that facilitates formation of a demolding layer, which suppresses any adhesion to the processing object, on the surface thereof is used. For example, when it is desirable to use a fluorinated mold release agent having a hydrophilic property, a metal which is an inorganic compound with a hydrophilic property like platinum, nickel, and, Si and SiO₂ can be used. Moreover, a hydrophilic group, such as a hydroxyl group, a carboxy group, an amino group, a carbonyl group, or a sulfo group, can be formed on a surface of the mold layer by chemical modification or the like.

When the mold layer 2 is too thick, the base pattern 1A of the base layer 1 is buried, so that it is desirable that the mold layer should be formed thin as far as the strength can be maintained, and for example, the mold layer is formed with a thickness less than or equal to 100 nm. Note that it is needless to say that the mold layer 2 can be formed with a multilayer structure with different materials depending on its application.

Next, an explanation will be given of how to manufacture the foregoing mold.

A method of manufacturing the mold of the present invention comprises a base layer formation step of forming the base layer with a predetermined pattern, and a mold layer formation step of forming the mold layer along the base pattern so as to form the mold pattern.

In the base layer formation step, first, a film or a substrate formed of a thermoplastic resin, or a material, such as a thermosetting resin or a photo-curable resin, is prepared, and a desired pattern is formed thereon. Examples of the thermoplastic resin are a cyclic-olefin-based resin like a cyclic olefin polymer or a cyclic olefin copolymer (COC), an acrylic resin, polycarbonate, vinyl ether, perfluoroalkoxylalkane (PFA), polytetrafluoroethylene (PTFE), polystyrene, and a polyimide-based resin.

The base layer 1 can be formed through any kinds of techniques, but if nanoimprinting techniques, such as a thermal imprinting and optical imprinting, are applied, it is preferable because the base layer can be formed easily, inexpensively, and can be formed by a high throughput. A master mold formed of, for example, a metal like nickel, a ceramic, a carbon material like glass-carbon, or silicon is heated at a temperature higher than or equal to the glass transition temperature of the thermoplastic resin used for the base layer 1. The heated mold is pressed against the film or the substrate formed of the thermoplastic resin to transfer a pattern of the master mold. Accordingly, the base layer having the base pattern 1A is formed. Needless to say, how to form the base pattern 1A is not limited to the foregoing fashion, and such a pattern can be formed by application of precise machine work or a semiconductor microfabrication technique.

In the mold layer formation step, the mold layer 2 is formed from a material with a strength, a demolding property and the like appropriate for imprinting.

For example, from the standpoint of the strength, it is appropriate if the mold layer 2 is formed from a material harder than the resin used for the base layer 1 at a molding temperature when the mold 100 is used. In consideration of the mold temperature in thermal imprinting, it is preferable to use a material harder than the resin used for the base layer 1 at least within a range from greater than or equal to 0 °C and to less than or equal to 100 °C. An example of such a material is an inorganic compound. More specifically, a metal or a metal compound, such as platinum (Pt), nickel (Ni), palladium, ruthenium, gold, silver, copper, ZnO, and indium tin oxide (ITO), Si, and SiO₂ can be used. Needless to say, other materials such as an organic compound like fluorinated resin can be used if it is harder than the base layer 1 at least within a range from greater than or equal to 0 °C to less than or equal to 100 °C.

Regarding the hardness, a Vickers hardness or a Brinell hardness can be compared using a hardness tester at a normal temperature or a molding temperature. Moreover, the hardness can be checked by carrying out a test through nanoindentation.

From the standpoint of demolding property, the mold can have a good demolding property if a material that suppresses any adhesion with the processing object or a material that facilitates formation of a demolding layer, which suppresses any adhesion with the processing object, on the surface is used. For example, when it is desirable to use a hydrophilic fluorinated mold release agent, metals which are hydrophilic inorganic compounds, such as platinum and nickel, Si, and SiO₂ can be used. Moreover, a hydrophilic group, such as a hydroxy group, a carboxy group, an amino group, a carbonyl group, or a sulfo group can be formed on the surface of the mold layer by chemical modification.

Regarding how to form such a mold layer 2, any methods can be applied, but examples of such methods are a method of depositing the material by chemical vapor deposition (CVD), physical vapor deposition (PVD), plating and the like. For example, metals, such as platinum (Pt) and nickel (Ni), can be formed by sputtering or vapor deposition. Moreover, it can be formed by silver mirror reaction. When a material like a fluorinated resin is used, a method of dissolving the material in a solution, and of dropping the solution over the base pattern 1A of the base layer 1 to perform spin coating, or a method of dipping the base layer 1 in the solution in which the material is dissolved can be applied. Note that if the mold layer 2 is too thick, the base pattern 1A of the base layer 1 is buried, so that it is preferable to make the mold layer 2 thin as far as the strength can be maintained. For example, the thickness can be set to less than or equal to 100 nm.

The mold formed in this fashion can transfer a pattern to a resin having a relatively similar glass transition temperature to that of the resin used for the base layer, so that there is an advantage that the glass transition temperature of the resin used for the mold is not limited by the glass transition temperature of the resin used for the processing object. In particular, there is a good effect that a pattern can be transferred to the same resin as the resin used for the base layer.

As shown in FIG. 2, a fine pattern product 200 of the present invention comprises the mold 100 of the present invention and a molding-target layer 3 formed by joining with the mold 100.

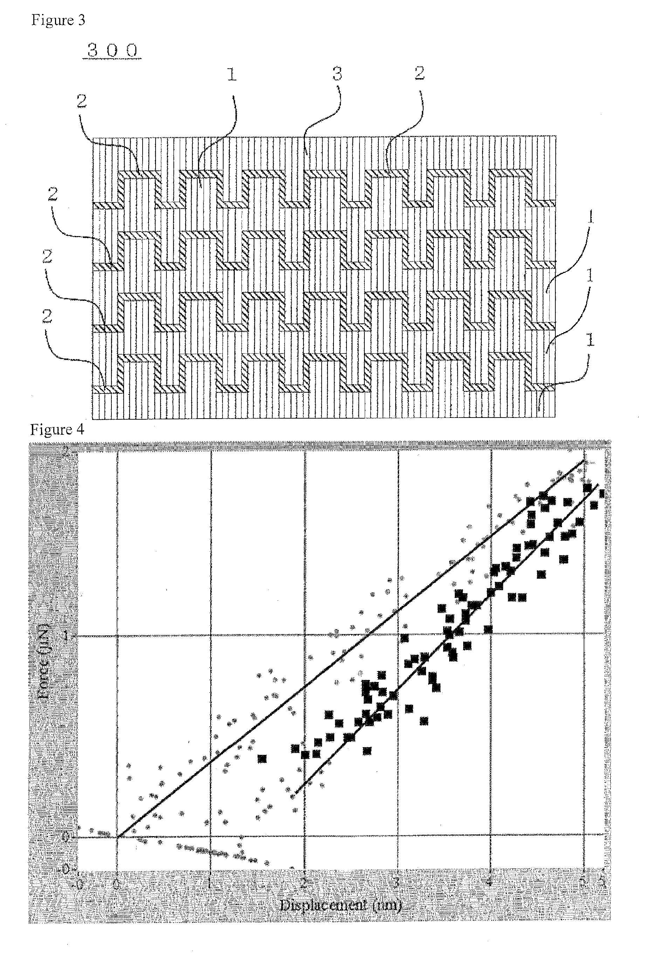

The material of the molding-target layer 3 is not limited to any particular one if the mold pattern 2A of the mold 100 can be transferred and can be joined together with the mold, and for example, resins, such as a thermoplastic resin, a thermosetting resin, and a photo-curable resin can be used.
Note that as shown in FIG. 3, the plurality of molds 100 of the present invention and the plurality of molding-target layers 3 can be stacked and joined together to form a fine pattern product 300 with a multilayer structure.

Next, an explanation will be given of how to manufacture the foregoing fine pattern product.

The method of manufacturing the fine pattern product of the present invention imprints the mold 100 of the present invention on the processing object, and joins both mold and processing object together.

Regarding imprinting, a general thermal imprinting technique or an optical imprinting technique can be applied. Moreover, a material which is likely to be joined together with (not likely to be released from) the mold 100 at the time of imprinting can be selected as the processing object.

For example, when the thermal imprinting technique is applied, the mold 100 and the processing object are heated at a temperature higher than the glass transition temperature of the processing object, and pressed against each other. Accordingly, the molding-target layer 3 and the mold layer 2 can be joined together.

The fine pattern product formed in this fashion can be used as, for example, a catalytic membrane for a fuel cell, a wavelength-selective film for selecting a wavelength of transmissive light, a transparent conducting film used in a touch panel.

When the fine pattern product is used as a catalytic membrane, it is appropriate if resins which allow a predetermined material, such as a material to be reacted or a material to be created, to transmit therethrough are selected for the base layer 1 and the molding-target layer 3, respectively, and a material which functions as a catalyst promoting the reaction of the foregoing material is selected as the mold layer 2. For example, perfluoroalkoxylalkane (PFA), polytetrafluoroethylene (PTFE) can be used for the base layer 1 and the molding target layer 3, and platinum, palladium, nickel, SiO₂ can be used for the mold layer 2.

Accordingly, a pattern which was conventionally difficult to form can be brought to action with the catalyst, so that the reaction efficiency can be improved if the surface area is set to be large.

Moreover, when the fine pattern product is used as a wavelength-selective film, it is appropriate if a resin which allows only light A having a wavelength within a predetermined range to transmit therethrough is selected for at least either one of the base layer 1 and the molding-target layer 3, and a material which absorbs light B having a wavelength within a predetermined range is selected for the mold layer 2. For example, cyclic olefin polymer, cyclic olefin copolymer (COC), or polycarbonate can be used for the base layer 1 and the molding-target layer 3, and ZnO or the like can be used for the mold layer 2. Note that a plurality of layers absorbing various lights can be formed as the mold layer 2. In this case, the foregoing mold layer formation step may be repeated to form such a plurality of layers as far as the pattern is not buried therein.

Accordingly, because a pattern which was conventionally difficult to form can be formed, such a pattern can selectively allow light to transmit therethrough, so that the light selectivity of the wavelength-selective film can be further improved.

Furthermore, when the fine pattern product is used as a transparent conductive film, it is appropriate if transparent resins are selected for the base layer 1 and the molding-target layer 3, respectively, and a conductive material is selected for the mold layer 2. For example, cyclic olefin polymer, cyclic olefin copolymer (COC), or polycarbonate can be used for the base layer 1 and the molding-target layer 3, and copper, nickel, platinum, gold, silver, or indium tin oxide (ITO) can be used for the mold layer.

Accordingly, a pattern which was conventionally difficult to form can be formed, optical reflection can be suppressed by such a pattern, resulting in further improvement of the optical transparency.

### Examples

An explanation will be given of examples of the present invention. A first example and a second example are for verifying the mold of the present invention from the standpoint of strength. A third example and a fourth example are for verifying the mold of the present invention from the standpoint of demolding property. A fifth example is an example case in which a pattern was transferred to a processing object using the mold of the present invention, and such a processing object was used as the mold of the present invention to transfer the pattern. Sixth to eighth examples are example cases in which a thermoplastic resin or a photo-curable resin was used as a resin for the base layer of the present invention.

Note that an imprinting device (VX-2000N-US) made by SCIVAX corporation was used for thermal imprinting. Moreover, an AFM (Dimension 3100 Scanning Probe Microscope made by Veeco Instruments Inc.,) was used for checking a condition of a pattern.

### <First Example>

The strength of the mold of the present invention was checked through a relation between stress and strain due to nanoindentation.
First, a cyclic olefin-based resin film (made by optes corporation, product name: zeonor film ZF-14-100, thickness: 100 µm) having a glass transition temperature (Tg) of 136 °C was prepared and used as a mold A.

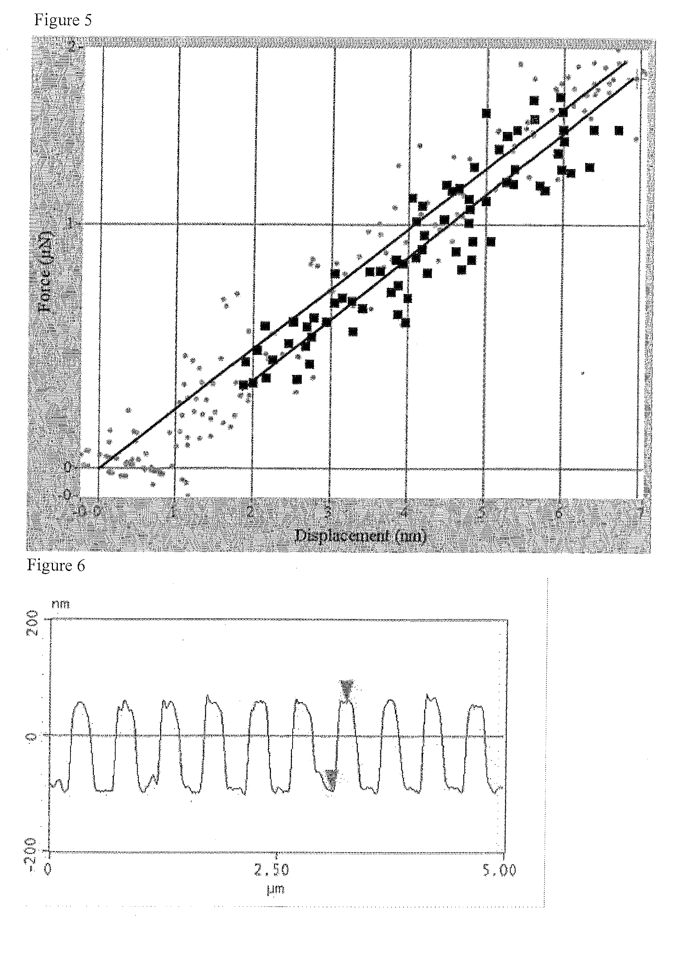

Using the mold A as a base layer, a mold B having a mold layer formed of platinum (Pt) harder than the mold A within a range at least from higher than or equal to 0 °C to lower than or equal to 100 °C was manufactured. The mold layer was formed through a technique of fixing the mold A on a silicon wafer and of performing vapor deposition of Pt on a surface at a thickness of several ten nm. Note that vapor deposition of Pt was performed under the following conditions.
Vapor deposition device: JFC auto fine coater made by japan electron datum corporation
Target: Pt
Vapor deposition time: 60 seconds
Degree of vacuum: 8 to 9 Pa
Current: 20 mA
Distance between sample and target: 70 mm
Next, regarding the mold A and the mold B, a relation between stress and strain by nanoindentation was checked. FIGS. 4, 5 show the results. Note that a circular point represents a relation between stress and strain when an indenter was pressed in, and a rectangular point represents a relation between stress and strain when the indenter was pulled back.

According to the experimental results, in FIG. 4, large strain was left when the indenter was pulled back, and the resin was deformed largely. Conversely, in FIG. 5, there were few strains left when the indenter was pulled back, and no deformation was left in the mold layer. Note that relations between stress and strain when pushed in and when pulled back are substantially same possibly because Pt is hard, the mold layer itself was pushed in without any deformation by the indenter, and the elastic behavior of the resin of the base layer was reflected. Accordingly, it becomes clear that the mold B of the present invention is not easily deformed in comparison with the mold A, and the strength is increased.

### <Second Example>

The shape of the mold of the present invention and that of the pattern of the processing object transferred from the foregoing mold were checked using an AFM.

The mold of the present invention was formed as follows.

First, using a thermal imprinting technique, a base pattern was transferred from a nickel metal mold having a pillar-like pattern with a diameter of approximately 250 nm and a depth of 140 to 150 nm to a cyclic olefin-based resin film (made by Optes corporation, product name: zeonor film ZF-16-100, thickness: 100 µm) having a glass transition temperature (Tg) of 163 °C, and the base layer was thus formed.

Thermal imprinting was performed as follows. First, the nickel metal mold heated beforehand at 205 °C was pressed against the foregoing resin film at a pressure of 2.0 MPa for 180 seconds. Next, the nickel metal mold and the resin film were both cooled to 100 °C, the resin film was removed from the nickel metal mold, and the base layer having a hall-like base pattern was thus manufactured.

Next, a mold layer of Ni having a thickness of approximately 20 nm or so was formed on the base layer by sputtering, and a mold C having a mold pattern was thus manufactured.

A fluorinated demolding layer was formed on the mold C, and a pattern was transferred plural times to a thin film (made by maruzen petrochemical co., ltd., thickness: 60 nm) formed of a methyl-phenyl-norbornene-based resin having a glass transition temperature (Tg) of 135 °C and formed on a sapphire substrate.

Thermal imprinting was performed as follows. First, the mold C heated beforehand at 160 °C was pressed against the thin film on the substrate at a pressure of 2 MPa for 180 seconds. Next, the mold and the substrate were both cooled to 100 °C, and the mold C was released from the substrate. A pillar-like pattern was thus formed on the resin thin film.

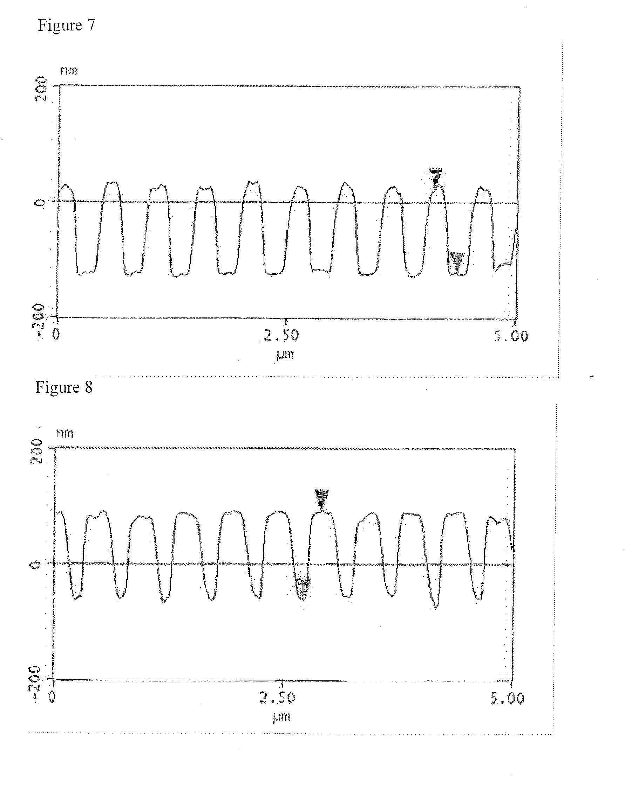

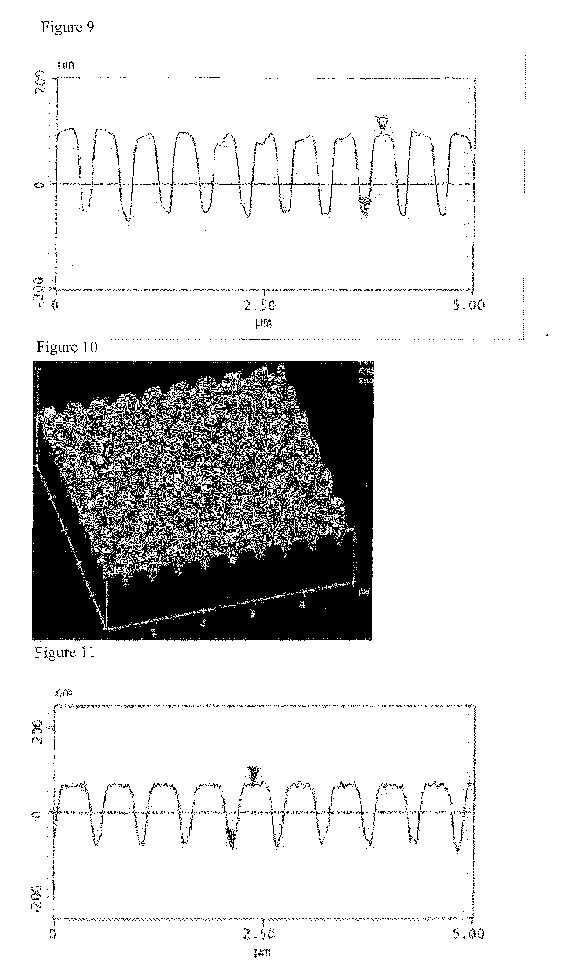

FIG. 6 is a graph showing a condition of a cross section of the base pattern before the mold layer of Ni was formed on the mold C, FIG. 7 is a graph showing a condition of a cross section of the mold pattern of the mold C after the pattern was transferred to the resin thin film on the substrate twenty six times, FIG. 8 is a graph showing a condition of a cross section of a molded pattern on the resin thin film transferred from the mold C at a second time, and FIG. 9 is a graph showing a condition of a cross section of a molded pattern on the resin thin film transferred from the mold C at a twenty seventh time, all of which were observed through an AFM, respectively.

As is clear from the results, the mold pattern of the mold C was hardly deteriorated, and the durability thereof was ensured by the mold layer.

As is clear from the results of the first and second examples, because a surface of the pattern can harden, the mold of the present invention has a strength sufficient to withstand several usages.

### <Third Example>

First, using a thermal imprinting technique, a base pattern was transferred from a nickel metal mold having a pillar-like pattern with a diameter of approximately 250 nm and a depth of 140 to 150 nm to a cyclic olefin-based resin film (made by optes corporation, product name: zeonor film ZF-14-100, thickness: 100 µm) having a glass transition temperature (Tg) of 136 °C, and a mold D was thus manufactured.

Thermal imprinting was performed as follows. First, the nickel metal mold heated beforehand at 170 °C was pressed against the resin film at a pressure of 2.0 MPa for 180 seconds. Next, the nickel metal mold and the resin film were both cooled to 100 °C, the nickel metal mold was released from the resin film, and the mold D having a hall-like base pattern was thus manufactured.

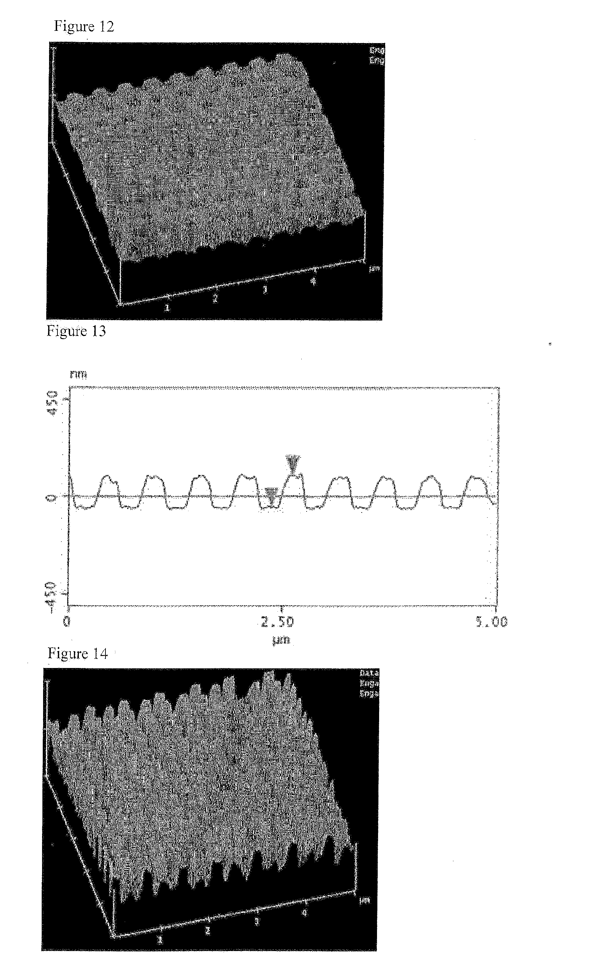

FIGS. 10 and 11 show results of observing a condition of the pattern of the nickel metal mold through an AFM, and FIGS. 12 and 13 show results of observing a condition of the pattern of the mold D through the AFM. Note that FIGS. 11 and 13 show a cross-sectional condition of the mold. As a result, the hall-like pattern having a diameter of approximately 250 nm and a depth of 140 to 150 nm was substantially uniformly transferred to the mold D.

The mold D was soaked in a fluorinated mold release agent (made by harves co., ltd., durasurf HD-2100Z) for two minutes, dried naturally, and baked for one hour by a convection oven. Accordingly, a mold E having a fluorinated demolding layer was manufactured. At this time, the mold B was poor wettability, and the demolding layer was not formed uniformly.

Moreover, the mold D was fixed on a silicon wafer, and Pt was deposited as a mold layer using a vapor deposition device (made by japan electron datum corporation, JFC auto fine coater), and a mold F having the mold D as a base layer was manufactured.
Note that vapor deposition of Pt was performed under the following conditions.
Target: Pt
Vapor deposition time: 60 seconds
Degree of vacuum: 8 to 9 Pa
Current: 20 mA
Distance between the sample and the target: 70 mm
A fluorinated demolding layer was formed on the mold F through the same fashion as that of the mold E, thereby manufacturing a mold G.

Moreover, a mold layer ofNi having a thickness of 10 nm or so was formed on the mold D by sputtering, and a mold H having a fluorinated demolding layer on a surface of the mold layer was manufactured through the same fashion as that of the mold E.

Next, using a thermal imprinting technique, patterns were transferred from the mold D, the mold E, the mold F, the mold G, and the mold H to respective cyclic olefin-based resin films (made by Ticona, product name: TOPA8007, thickness: 100 µm) having a glass transition temperature (Tg) of 80 °C.

Thermal imprinting was performed as follows. First, the mold D, the mold E, the mold F, the mold G, and the mold H heated beforehand at 110 °C were pressed against respective resin films at a pressure of 1.5 MPa for 60 seconds. Next, the mold and the resin film were both cooled to 100 °C, and the mold was released from the resin film. Accordingly, a pillar-like pattern was transferred on the resin film.

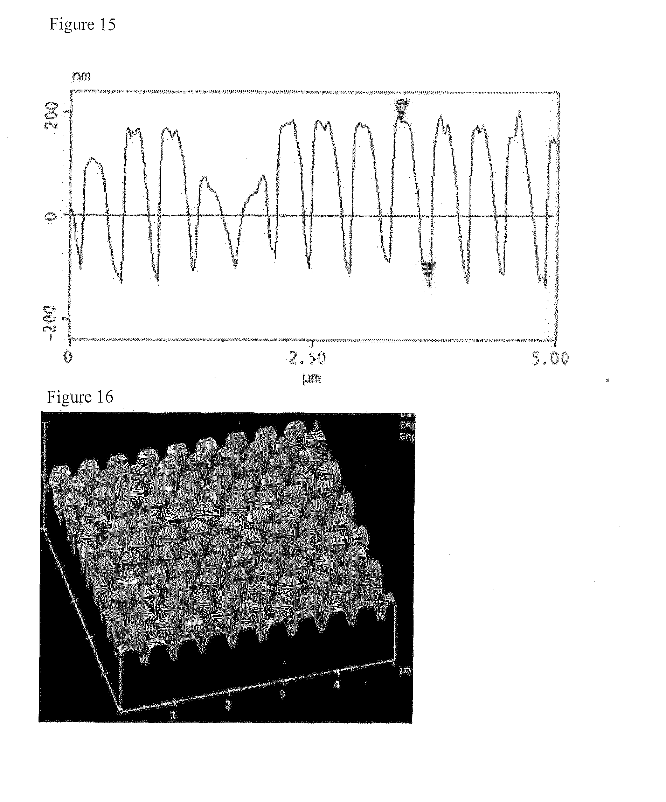

As a result, the mold D, the mold E, and the mold F adhered to the respective resin films. FIGS. 14 and 15 show a condition of a pattern on the resin film which was observed through an AFM after the mold D was forcedly-released from the resin film. It is clear from the figures that elongation or the like was caused and the pattern became nonuniform.

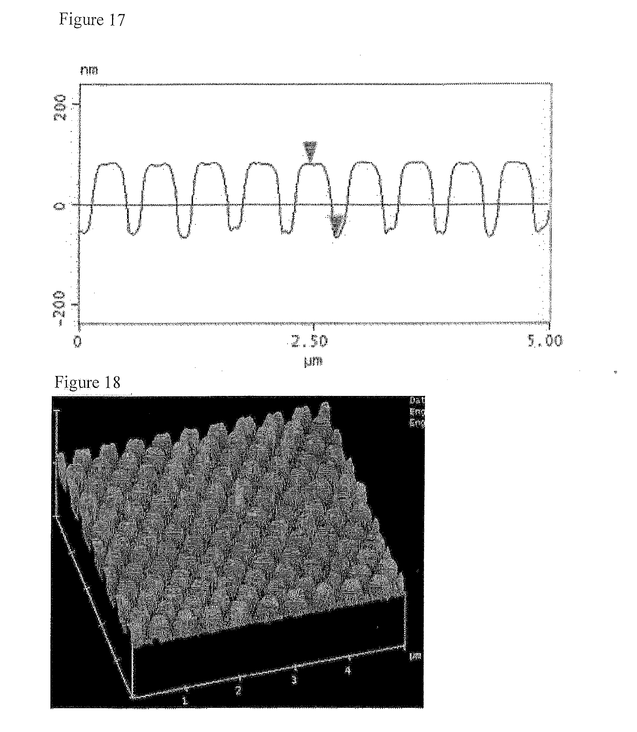

In contrast, as shown in FIG. 16 to 19, patterns which were substantially same as the pattern of the nickel metal mold were formed and transferred from the mold G and the mold H (see table 1).

**[Table 1]**

| Mold | Material of base layer | Mold layer | Demolding layer | Imprinting result |
|---|---|---|---|---|
| D | ZF-14 | - | - | × |
| E | | | Present | × |
| F | | Pt vapor deposition | - | × |
| G | | | Present | ○ |
| H | | N i 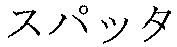 | present | ○ |

### <Fourth Example>

First, using a thermal imprinting technique, a base pattern was transferred from a nickel metal mold having a pillar-like pattern with a diameter of approximately 250 nm and a depth of 140 to 150 nm to a cyclic olefin-based resin film (made by optes corporation, product name: zeonor film ZF-16-100, thickness: 100 µm) having a glass transition temperature (Tg) of 163 °C, and a mold I was thus manufactured.

Thermal imprinting was performed as follows. First, the nickel metal plate heated beforehand at 210 °C was pressed against the resin film at a pressure of 2.0 MPa for 180 seconds. Next, the nickel metal mold and the resin film were both cooled to 100 °C, the nickel metal mold was released from the resin film, and the mold I having a hall-like base pattern was thus manufactured.

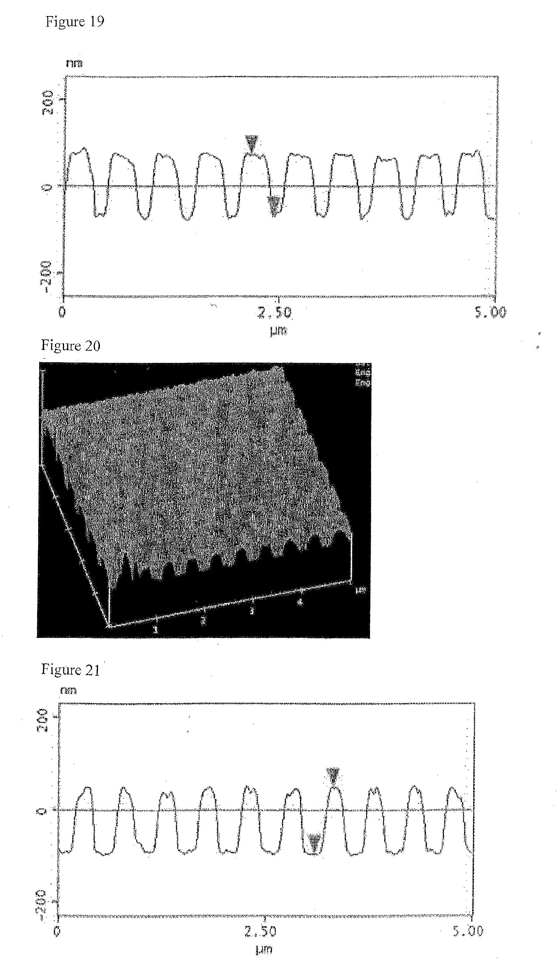

FIGS. 20 and 21 show results of observing the pattern of the mold I through an AFM. Note that FIG. 21 shows a condition of a cross section of FIG. 20. As a result, a hall-like pattern having a diameter of 250 nm and a depth of 140 to 150 nm was substantially uniformly formed on the mold 1.

Next, the mold I was fixed on a silicon wafer, Pt was deposited as a mold layer thereon through the same fashion as that of the mold F, and a fluorinated demolding layer was formed on the surface of the mold layer through the same fashion as that of the mold E, thereby manufacturing a mold J having the mold I as a base layer.

Moreover, a mold layer of Ni having a thickness of 10 nm or so was formed on the mold I by vapor deposition, and a mold K having a fluorinated demolding layer formed on the surface of the mold layer was manufactured through the same fashion as that of the mold E.

Next, using a thermal imprinting technique, patterns were transferred from the mold I, the mold J, and the mold K to respective cyclic olefin-based resin films (made by optes corporation, product name: zeonor film ZF-14-100, thickness: 100 µm) having a glass transition temperature (Tg) of 136 °C.

Thermal imprinting was performed as follows. First, the mold heated beforehand at 160 °C was pressed against the resin film at a pressure of 2.0 MPa for 180 seconds. Next, the mold and the resin film were both cooled to 100 °C, and the mold was released from the resin film. Accordingly, a pillar-like pattern was formed on the resin film.

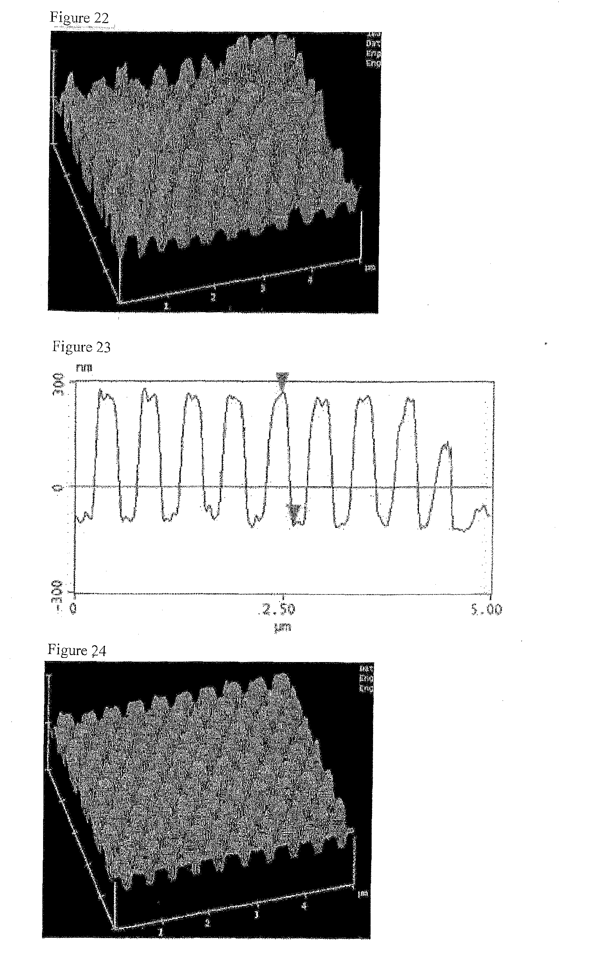

As a result, the mold I adhered to the resin film. FIGS. 22 and 23 show a condition of a pattern on the resin film which was observed through an AFM after the mold D was forcedly-released from the resin film. It is clear from the figures that elongation or the like was caused and the pattern became nonuniform.

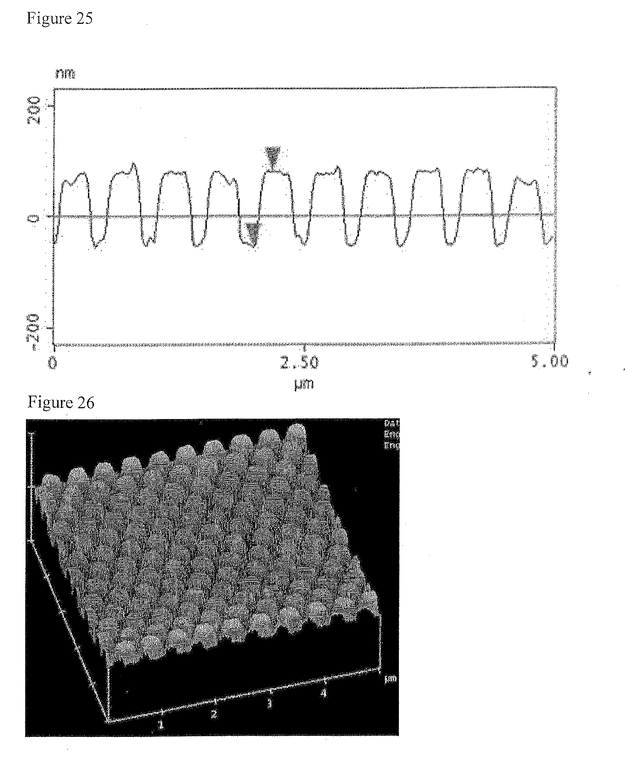

Conversely, as shown in FIGS. 24 to 27, patterns which were substantially same as the pattern of the nickel metal mold were formed and transferred from the mold J and the mold K (see table 2).

**[Table 2]**

| Mold | Material of base layer | Mold layer | Demolding layer | Imprinting result |
|---|---|---|---|---|
| I | ZF-16 | - | - | × |
| J | | Pt vapor deposition | Present | ○ |
| K | | Ni vapor deposition | Present | ○ |

As is clear from the results of third and fourth examples, the mold of the present invention can transfer a uniform pattern because the demolding layer is formed even if a processing object is formed of the same kind of resin as the material of the mold. Therefore, the material can be selected freely without the material of the base layer being restricted by the material of the processing object.

### <Fifth Example>

A cyclic olefin-based resin film (made by optes corporation, product name: zeonor film ZF-14-100, thickness: 100 µm) on which a pattern was transferred from the foregoing mold J and which had a glass transition temperature (Tg) of 136 °C was used as a base layer, Pt was deposited thereon as a mold layer through the same fashion as that of the mold F, and a fluorinated demolding layer was formed on the surface of the mold layer through the same fashion as that of the mold E, thereby manufacturing a mold L.

Next, using a thermal imprinting technique, a pattern was transferred from the mold L to a cyclic olefin-based resin film (made by Ticona, product name: TOPAS8007, thickness: 100 µm) having a glass transition temperature (Tg) of 80 °C.

Thermal imprinting was performed as follows. First, the mold heated beforehand at 110 °C was pressed against the resin film at a pressure of 1.5 MPa for 60 seconds. Next, the mold and the resin film were both cooled to 50 °C, and the mold was released from the resin film. Accordingly, a pillar-like pattern was formed on the resin film.

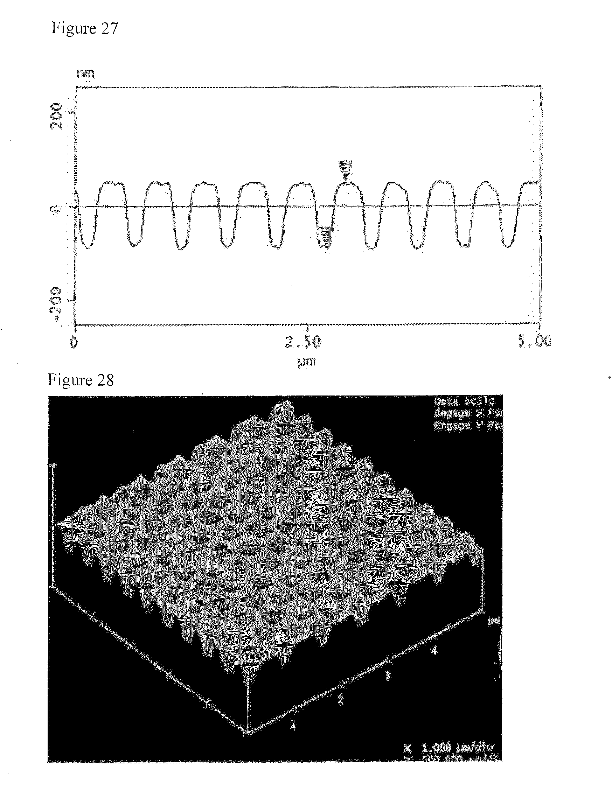

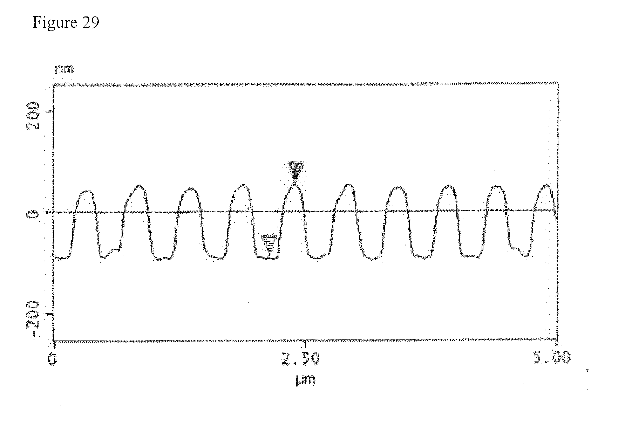

FIGS. 28 and 29 show a result of observing a condition of the pattern on the resin film transferred from the mold L through an AFM.

As a result, substantially same hall-like pattern as the pattern of the mold J was formed and transferred from the mold L (see table 3). Accordingly, when the mold J was manufactured from the Ni metal mold, and the mold J was used as a master mold to manufacture the mold L, the pattern was precisely transferred from the mold L.

**[Table 3]**

| Mold | Material of base layer | Mold layer | Demolding layer | Imprinting result |
|---|---|---|---|---|
| L | ZF-14 | Pt vapor deposition | Present | ○ |

According to the result of the fifth example, it is possible for the mold of the present invention to replicate a mold having the same pattern as that of a conventional mold by repeating transfer twice from the conventional mold.

### <Sixth Example>

Bisallylnadic-imide (made by maruzen, product name: BANI-M) was dissolved in methyl-ethyl-ketone (MEK) to prepare a 50% solution, such solution was applied on an aluminum plate, and a thin film having a thickness of 15 µm was formed. It was subjected to temperature rising to 75 °C to make it softened, a fine-pattern metal mold processed by a mold release agent beforehand was pressed against it, and caused those to harden for one hour at a temperature of 250 °C to form a base layer, thereby manufacturing a mold.

### <Seventh Example>

A resin acquired by cationic polymerization of tricyclodecanyl-vinyl-ether and 4-vinyloxyacrylate-butyl at a composition ratio of 8:2 (molar ratio) was dissolved in toluene to prepare a 30% solution, such solution was applied on an Si substrate and dried, and a thin film having a thickness of 15µm was formed. It was subjected to temperature rising to 75 °C, a fine-pattern metal mold was pressed against it to transfer a pattern, those were subjected to temperature rising to 165 °C as those were, caused those to harden for 10 minutes to form a base layer, thereby manufacturing a mold. Note that the glass transition temperature of the resin prior to hardening was 67 °C, but the glass transition temperature of the resin after hardening became 105 °C. Accordingly, it was possible to manufacture a mold which had high heat resistance and which was able to be used with a resin having a higher glass transition temperature by performing imprinting at a low temperature and then performing heating.

### <Eighth Example>

A mixture of cyclohexanedimethanol-monovinylmonoglycidyletehr, bisphenol-A-diglycidylether hydride (2:8) in which IRGACURE250 as a photo initiator was added was applied on a polyethylene-terephthalate substrate, a fine-pattern metal mold processed by a mold release agent beforehand was pressed against it, and those were irradiated with UV to form a base layer, thereby manufacturing a mold.
As is clear from the results of sixth to eighth examples, it is possible to use a thermosetting resin and a photo-curable resin as a base layer.

## Claims

1. A mold for nanoimprinting, the mold including a mold pattern to be transferred to a processing object, the mold comprising:
a base layer formed of a resin and including a predetermined base pattern; and
a mold layer formed along the base pattern so as to shape the mold pattern.

2. A mold for nanoimprinting, the mold including a mold pattern to be transferred to a processing object, the mold comprising:
a base layer including a predetermined base pattern; and
a mold layer formed along the base pattern so as to shape the mold pattern and having a thickness less than or equal to 100 nm.

3. The mold according to claim 1 or 2, wherein the mold layer is formed of a material harder than the resin at least at a molding temperature of performing imprinting on the processing object.

4. The mold according to claim 1 or 2, wherein the mold layer is formed of an inorganic compound.

5. The mold according to claim 1 or 2, wherein the mold layer is formed of platinum or nickel.

6. The mold according to claim 1 or 2, further including a hydrophilic group on a surface of the mold layer.

7. The mold according to claim 1 or 2, wherein the resin is a thermoplastic resin.

8. The mold according to claim 1 or 2, wherein the resin is any one of followings: a cyclic olefin-based resin; an acrylic resin; polycarbonate; vinyl ether; and fluorinated resin.

9. The mold according to claim 1 or 2, wherein the resin is a thermosetting resin or a photo-curable resin.

10. The mold according to claim 1 or 2, wherein the resin has a water absorption percentage less than or equal to 3 %.

11. The mold according to claim 1 or 2, wherein the base pattern has a minimum size in a planar direction less than or equal to 100 µm.

12. The mold according to claim 1 or 2, further comprising a demolding layer formed on a surface of the mold pattern and suppressing any adhesion with the processing object.

13. The mold according to claim 12, wherein the demolding layer is a fluorinated mold release agent.

14. A method of manufacturing a mold for nanoimprinting, the mold including a mold pattern to be transferred to a processing object, the method comprising:
a base layer formation step of forming a base layer formed of a resin and including a predetermined base pattern; and
a mold layer formation step of forming a mold layer along the base pattern so as to shape the mold pattern.

15. A method of manufacturing a mold for nanoimprinting, the mold including a mold pattern to be transferred to a processing object, the method comprising:
a base layer formation step of forming a base layer including a predetermined base pattern; and
a mold layer formation step of forming a mold layer along the base pattern so as to shape the mold pattern and so as to have a thickness less than or equal to 100 nm.

16. The mold manufacturing method according to claim 14 or 15, wherein the mold layer formation step forms the mold layer by any one of following fashions: physical vapor deposition (PVD); chemical vapor deposition (CVD); and plating.

17. The mold manufacturing method according to claim 14 or 15, wherein the base layer formation step forms the base layer by imprinting.

18. The mold manufacturing method according to claim 14 or 15, further comprising a demolding layer formation step of forming a demolding layer on a surface of the mold pattern, the demolding layer suppressing any adhesion with the processing object.

19. A fine pattern product comprising:
the mold according to claim 1 or 2; and
a molded layer formed by joining with the mold.

20. A method of manufacturing a fine pattern product by joining and imprinting the mold according to claim 1 or 2 with a processing object.
